(19) Europäisches Patentamt
European Patent Office
Office européen des brevets

(11) **EP 4 276 060 A2**

(12) **EUROPÄISCHE PATENTANMELDUNG**

(43) Veröffentlichungstag:
**15.11.2023 Patentblatt 2023/46**

(21) Anmeldenummer: **23188146.7**

(22) Anmeldetag: **26.06.2020**

(51) Internationale Patentklassifikation (IPC):
**B82Y 10/00** (2011.01)

(52) Gemeinsame Patentklassifikation (CPC):
**C30B 29/04; C30B 31/22; C30B 33/02;** B82Y 10/00

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **27.06.2019 DE 102019117423**

(62) Dokumentnummer(n) der früheren Anmeldung(en) nach Art. 76 EPÜ:
**20735338.4 / 3 990 684**

(71) Anmelder: **Quantum Technologies GmbH
04103 Leipzig (DE)**

(72) Erfinder:
• **Meijer, Jan Berend
04109 Leipzig (DE)**

• **Pezzagna, Sébastien
04109 Leipzig (DE)**
• **Lühmann, Tobias
04109 Leipzig (DE)**
• **Wunderlich, Ralf
04109 Leipzig (DE)**

(74) Vertreter: **Hecht, Jan-David
Patentanwaltskanzlei Dr. Hecht
Ranstädter Steinweg 28
04109 Leipzig (DE)**

Bemerkungen:
Diese Anmeldung ist am 27-07-2023 als Teilanmeldung zu der unter INID-Code 62 erwähnten Anmeldung eingereicht worden.

(54) **VERFAHREN ZUR ERZEUGUNG ZUMINDEST EINES DETERMINISTISCHEN FARBZENTRUMS IN EINER DIAMANTSCHICHT, DIAMANTSCHICHT MIT ZUMINDEST EINEM DETERMINISTISCHEN NV-ZENTRUM UND DOTANDEN SOWIE VERWENDUNG EINER DIAMANTSCHICHT MIT ZUMINDEST EINEM DETERMINISTISCHEN FARBZENTRUM**

(57) Die vorliegende Erfindung betrifft ein Verfahren zur Erzeugung zumindest eines deterministischen Farbzentrums in einer Diamantschicht. Dadurch, dass in einem ersten Schritt in der Diamantschicht zumindest ein Dotand implantiert wird und in einem zweiten Schritt in der Diamantschicht mittels niederenergetischem Ionenbeschuss zumindest ein Fremdatom zur Bildung des Farbzentrums eingebaut wird, können sehr hohe Umwandlungsraten von mehr als 70% erzielt werden. Dies ist eine bedeutende Steigerung gegenüber undotiertem Diamant, bei dem die Umwandlungsraten nur etwa 6% betragen. Dabei kann durch eine Dotierung mit einem Donator, wie Phosphor, Sauerstoff oder Schwefel, eine sehr gute Umwandlung in negativ geladene Farbzentren erreicht werden, die für Qubit-Anwendungen eingesetzt werden.

Fig. 6

EP 4 276 060 A2

**Beschreibung**

Die vorliegende Erfindung betrifft ein Verfahren zur Erzeugung zumindest eines deterministischen Farbzentrums in einer Diamantschicht nach dem Oberbegriff von Anspruch 1.

Diamanten besitzen viele außergewöhnliche physikalische und chemische Eigenschaften. Die mechanischen Besonderheiten wie sehr hohe Härte, Wärmeleitfähigkeit und Reaktionsbeständigkeit sind seit Jahrhunderten bekannt und werden in vielen Anwendungen genutzt. Die optischen Eigenschaften von Diamant werden schon seit den 70er-Jahren des letzten Jahrhunderts untersucht, aber mit dem Aufkommen von neuen Methoden zur Nanostrukturierung und Herstellung von Diamant durch chemische Gasphasenabscheidung (CVD) erschließen sich seit Kurzem neue aufregende Forschungs- und Anwendungsgebiete in der Nanooptik und Nanophotonik.

Heutzutage ist es möglich, synthetisch Diamant in einer hohen Isotopenreinheit mit kernspinfreien Kohlenstoff-Atomen ($^{12}$C) und mit bestimmten Kristalldefekten herzustellen. Insbesondere eröffnet die Kontrolle über die Art und Konzentration von Fremdatomen neue Möglichkeiten, Diamant mit anwendungsspezifischen optischen und elektronischen Attributen auszustatten.

Im Besonderen die Quantentechnologie profitiert von den außerordentlichen Eigenschaften von Diamant. Dabei umfasst die Quantentechnologie drei große Bereiche: Quantencomputer, Quantkryptografie und Quantensensorik.

Das präzise Erfassen physikalischer Größen ist die Grundlage sämtlicher Naturwissenschaften und notwendige Voraussetzung sowie Triebfeder nahezu aller technischen Weiterentwicklungen. Zwar werden gegenwärtig klassische Sensorprinzipien verfeinert, miniaturisiert und kombiniert, allerdings ist abzusehen, dass damit keine entscheidende Steigerung der bisher erreichten Schlüsselparameter wie Empfindlichkeit sowie Spezifität erreicht werden kann. Quantenphänomene wie Kohärenz, Superposition und Verschränkung hingegen können dazu genutzt werden, Größen wie Druck, Temperatur, Position, Zeit und Bewegung bzw. Beschleunigung, Lage, Gravitation oder elektrische und magnetische Felder mit bisher unerreichter Genauigkeit nachzuweisen. Quantensensoren greifen dabei auf verschiedene Quantsysteme zurück, die jeweils spezifische Stärken aufweisen.

Ein solches Quantsystem lässt sich mit Hilfe von bestimmten Defekten in Diamanten (Farbzentren genannt) realisieren. Ein solches Farbzentrum ist z.B. das Stickstoff-Vakanz-Zentrum in Diamant. Stickstoff-Vakanz-Zentren (NV-Zentren) sind atomare Systeme aus einem Stickstoffatom und einer Kohlenstofffehlstelle in Diamant. Sie absorbieren Licht im Wellenlängenbereich von circa 450nm bis 637nm und emittieren rotes Licht. Da die Leuchtkraft dieser NV-Zentren von der Stärke eines äußeren Magnetfeldes abhängt und die Zentren atomar klein sind, können sie genutzt werden, um Magnetfelder mit hoher lokaler Auflösung aber auch guter Empfindlichkeit zu messen. Die üblichen hochsensitiven Magnetfeldsensoren, wie etwa die SQUID-Sensoren, funktionieren nur bei extremer Kühlung, was ihren Betrieb sehr kostenintensiv und technologisch aufwändig macht. NV-Zentren können hier eine wichtige Alternative sein, da diese bei Raumtemperatur nutzbar sind und ihre Quanteneigenschaften beibehalten - im Gegensatz zu beispielsweise SQUID-Sensoren.

Einen ebenfalls sehr zukunftsträchtigen Markt stellt auch die Quantencomputertechnologie dar. Auch wenn die Nützlichkeit für den normalen Computergebrauch zu Hause heute als sehr gering eingestuft wird, könnten Quantencomputer in einigen speziellen Gebieten den klassischen Computer verdrängen und durch ihre Beschaffenheit deutlich mehr Rechenleistung in diesen Gebieten zur Verfügung stellen.

In klassischen Computern werden Informationen in Sequenzen von Bits zerlegt. Ein Bit kann dabei in zwei unterscheidbaren Zuständen vorkommen, die im Allgemeinen mit 0 und 1 bzw. "An" und "Aus" bezeichnet werden. Das gleiche Prinzip kann auch bei quantenmechanischen Systemen benutzt werden. Es ist jedoch anzumerken, dass in einem Quantensystem zwei Zustände als unterscheidbar gelten, wenn sie sich mindestens in einer Quantenzahl unterscheiden. Der Hauptunterschied zwischen klassischer und quantenmechanischer Informationstechnik liegt darin, dass sich im quantenmechanischen Fall das System nicht unbedingt in einem der beiden Zustände 0 und 1 befinden muss. Vielmehr kann es sich in einer Superposition, also einer Linearkombination beider Zustände befinden. Im Rahmen der vorliegenden Erfindung werden die Einheit einer solchen Quanteninformation und auch die Quanteninformation selbst als "Qubit" bezeichnet.

Im Gegensatz zu den klassischen Bits heutiger Computer können Qubits somit viel mehr Informationen verarbeiten und bieten daher das Potenzial für Computer mit nie dagewesener Rechenkapazität. Besonders die Herstellung solcher Qubits ist derzeit ein Thema in der Wissenschaft, in das viel Forschungsarbeit investiert wird. Wissenschaftler suchen nach dem besten Weg, Qubits herzustellen und sie gemäß der Quantengesetze zu Recheneinheiten miteinander zu verbinden.

Besonders im Fokus der Entwicklung von Qubits und damit zur Entwicklung von Quantencomputern liegt wie im Bereich der Quantensensorik das NV-Zentrum in Diamanten. Dieses festkörperbasierte Quantsystem hat gegenüber alternativen Qubit-Systemen einige Vorteile. Die experimentelle Implementierung ist im Vergleich zu Atomen und Ionen, die zur Isolierung in aufwendigen evakuierten Fallen gehalten werden, einfacher. Die lange Elektronenspinkohärenzzeit hebt das NV-Zentrum gegenüber anderen Festkörpersystemen wie Halbleiter-Quantenpunkten und Supraleitern hervor. Zurückzuführen ist diese auf die nahezu kernspinfreie Matrix sowie die geringe Kopplung von Elektronen an Photonenzustände des Gitters bedingt durch die hohe Debye-Temperatur von Diamant. Ein weiterer Vorteil ist, dass das negativ geladene NV-Zentrum (NV$^-$) diese Spineigenschaften selbst bei Raumtemperatur aufweist, was das Betreiben von Quantenbauelementen unter Normalbedingungen denkbar macht. Darüber hinaus stellen Kohlenstoffkerne ($^{13}$C) mit Kernspin nicht nur eine Quelle von Dekohärenz dar, sondern sind in geringen Konzentrationen auch sinnvoll für Quantentechnologieanwendungen einsetzbar.

Herausfordernd ist jedoch die gezielte (deterministische) Herstellung und genaue Positionierung einzelner oberflächennaher Farbzentren, beispielsweise NV-Zentren. Einmal hergestellt, können sie nicht mehr bewegt werden.

Bekannt ist beispielsweise aus der US 7 122 837 B2, NV-Zentren dadurch zu erzeugen, dass Stickstoff gleichzeitig mit dem Diamantwachstum eingebracht wird oder nach abgeschlossenen Diamantwachstum Stickstoff implantiert wird. Dieses Verfahren kann auch für andere Atomsorten, wie Wasserstoff, Bor, Phosphor und Kohlenstoff verwendet werden, um bestimmte Farbzentren herzustellen. Die hierdurch erzielten Umwandlungsraten von implantiertem Stickstoff in NV-Zentren sind allerdings sehr gering.

Aus der EP 3 098 335 B1 ist bekannt, die Ladungsstabilität von NV$^-$ in Diamant über eine Dotierung mit beispielsweise Phosphor, Arsen, Schwefel oder Bor-Wasserstoff-Komplexen sehr hoch einzustellen. Allerdings wird dadurch das Problem der nur sehr geringen Umwandlungsraten nicht gelöst.

Oberflächennahe Farbzentren, beispielsweise NV-Zentren, können durch die Bestrahlung mit "langsamen" niederenergetischen Ionen, der sogenannten Shallow Implantation, hergestellt werden. Im Fall der niederenergetischen Ionen ergeben sich allerdings im Vergleich zur Bestrahlung mit hohen kinetischen Energien nur Umwandlungsraten von wenigen Prozent, so wie es für die Methoden der US 7 122 837 B2 und der EP 3 098 335 B1 der Fall ist. So sind hier 20-50 Ionen notwendig, die implantiert werden müssen, um ein oberflächennahes NV-Zentrum zu erzeugen. Diese Ineffizienz führt zu vielen Defekten innerhalb des Diamanten und stört die Eigenschaften des NV-Zentrums.

Es ist daher Aufgabe der vorliegenden Erfindung, ein Verfahren bereitzustellen, mit dem hohe Umwandlungsraten von eingebrachten Ionen in Farbzentren ermöglicht werden. Insbesondere sollen diese Umwandlungsraten zumindest 50% betragen.

Diese Aufgabe wird gelöst mit dem erfindungsgemäßen Verfahren nach Anspruch 1, der erfindungsgemäßen Diamantschicht nach Anspruch 10 und der erfindungsgemäßen Verwendung nach Anspruch 11. Vorteilhafte Weiterbildungen sind in den Unteransprüchen und in der nachfolgenden Beschreibung zusammen mit den Figuren angegeben.

Erfinderseits wurde erkannt, dass diese Aufgabe in überraschender Art und Weise dadurch gelöst werden kann, dass in einem ersten Schritt in einer Diamantschicht ein Dotand implantiert und in einem zweiten Schritt mittels Ionenbeschuss ein Fremdatom zur Bildung des Farbzentrums eingebaut wird, wobei der Ionenbeschuss mit Fremdatomen mit einer Ionenfluenz bis zu $10^{10}$ cm$^{-2}$ erfolgt. Dadurch können sehr hohe Umwandlungsraten von mehr als 70% erreicht werden. Durch die hohen Umwandlungsraten ergibt sich für das erfindungsgemäße Verfahren eine erhöhte Wahrscheinlichkeit zur erfolgreichen Verknüpfung bzw. Verschaltung einzelner Farbzentren, insbesondere NV-Zentren, um dadurch nutzbare Qubit-Register oder Qubit-Sensoren herzustellen, die jeweils aus zwei und mehr Qubits bestehen. Außerdem können so oberflächennahe Schichten mit Farbzentren erzeugt werden, ohne dass eine zusätzliche Oberflächenbearbeitung, beispielsweise ein Oberflächenabtrag, erforderlich wäre.

Eine "Diamantschicht" kann im Rahmen der vorliegenden Erfindung sowohl eine Lage in einem Diamant-Bulkmaterial sein als auch eine definierte Diamantlage, die auf einem materialgleichen oder materialfremden Substrat abgeschieden wurde.

Erfinderseits wird vermutet, dass sich beispielsweise in Bezug auf NV-Zentren normalerweise hochbeweglicher Wasserstoff an der Oberfläche der Diamantschicht anzulagern scheint und dort einen NVH-Komplex bildet, der nicht nutzbar ist. Außerdem sind Defekte (Vakanzen - V), die durch den Stickstoff-Ionenbeschuss, auch wenn dieser niederenergetisch erfolgt, entstehen, beweglich und lagern sich an der Oberfläche an, wo sie für die Bildung von NV-Zentren nicht mehr zur Verfügung stehen.

Durch den Dotand, insbesondere einen Donator, scheint nun eine Bindung des Wasserstoffs (Donator-H) zu erfolgen, wodurch ebenfalls ein Donator erzeugt zu werden scheint. Dadurch und durch den eingebrachten Donator bzw. Akzeptor selbst erfolgt eine Ladung der Vakanz (V$^-$ bzw. V'), wodurch die Vakanz unbeweglich wird und nicht mehr zur Oberfläche diffundiert, sondern zur Bildung des Farbzentrums zur Verfügung steht. Durch die Dotanden werden Frenkel-Defekte (Vakanz mit Zwischengitteratom $V^0$-$C_I$) negativ geladen → V$^-$-C. Diese dissoziieren bei 500°C zu V$^-$ und $C_I^0$. Es stehen daher mehr V$^-$ zur NV-Bildung zur Verfügung. In Bor oder bei intrinsischen Diamanten sind die Frenkel-Defekte vorwiegend neutral und rekombinieren (heilen aus).

Das erfindungsgemäße Verfahren zur Erzeugung zumindest eines deterministischen Farbzentrums in einer Diamantschicht ist dadurch gekennzeichnet, dass in einem ersten Schritt in der Diamantschicht zumindest ein Dotand implantiert wird und in einem zweiten Schritt in der Diamantschicht mittels niederenergetischem Ionenbeschuss zumindest ein Fremdatom zur Bildung des Farbzentrums eingebaut wird, wobei der Ionenbeschuss mit Fremdatomen mit einer Ionenfluenz bis zu $10^{10}$ cm$^{-2}$ erfolgt.

In einer vorteilhaften Weiterbildung ist vorgesehen, dass als Dotand ein Donator, bevorzugt Phosphor, Sauerstoff, Schwefel oder Lithium, oder ein Akzeptor, bevorzugt Bor, verwendet wird. Es können auch Mischungen von mehreren Dotanden, auch Mischungen von Donatoren und Akzeptoren verwendet werden, um besondere Anpassungen vorzunehmen. Schwefel wird hiervon am meisten bevorzugt, da damit die höchsten Umwandlungsraten von größer gleich 70%, insbesondere von 75,3%, erzielt werden können. Dies ist allerdings gänzlich unerwartet und überraschend, weil Schwefel als schlechter Donator für Diamant gilt, da man bei Hall-Messungen keine freien Ladungsträger nachweisen kann. Vor allem scheint Schwefel dafür zu sorgen, dass Wasserstoff gebunden wird, wodurch die Umwandlungsrate erhöht wird. Auch Phosphor (ca. 60%) und Sauerstoff (ca. 70%) sind hervorragend geeignet.

Auch die Veröffentlichung Karin Groot-Berning et al.: "Passive charge state control of nitrogen-vacancy centres in diamond using phosphorous and boron doping", Phys. Status Solidi A 211, No. 10, 2268-2273 (2014) beschreibt schon einen zweistufigen Prozess mit einer Dotierung und einer anschließenden Fremdatomimplantation mit Stickstoff. In dieser Untersuchung ging es darum, die erzeugten NV-Zentren zu stabilisieren. Es wurden dafür Ionenfluenzen von mehr als $10^{11}$ cm$^{-2}$ verwendet, wobei Umwandlungsraten von etwa 5% ermittelt wurden. Mit dem erfindungsgemäßen Verfahren können nun aber wesentlich höhere Umwandlungsraten erzielt werden, was wohl daran liegt, dass aufgrund der deutlich reduzierten Ionenfluenzen von nur bis zu $10^{10}$ cm$^{-2}$ wesentlich weniger Punktdefekte bzw. Vakanzen erzeugt werden. Solche Punktdefekte bzw. Vakanzen würden aber zu einer zusätzlichen p-Dotierung bzw. Trapping-Zentren führen, was wiederum die n-Dotierung durch beispielsweise Phosphor oder Schwefel kompensiert bzw. Landungsträger bindet, wodurch keine freien negativ geladenen Punktdefekte entstehen können, womit die Umwandlung von N in NV verhindert würde.

In einer vorteilhaften Weiterbildung ist vorgesehen, dass das Fremdatom ausgewählt ist aus der Gruppe Stickstoff, Magnesium, Kohlenstoff, Blei, Bor, Edelgase, Silizium, Übergangsmetalle und Zinn. In Bor dotiertem Diamanten bilden sich bei 800°C vermehrt Divakanzen (V-V) (stärker als in intrinsischem Diamant, in N-Typ Diamant wird dies nicht beobachtet oder nur ganz schwach). Für die Bildung von beispielsweise SiV benötigt man (V-V), was somit in Bor Diamanten zur Erhöhung der Umwandlungsrate bei Silizium-Fremdatomen in SiV führt. Dadurch können vielversprechende Farbzentren mit hoher Umwandlungsrate hergestellt werden.

Eine bevorzugte Kombination stellt Schwefel als Donator und Stickstoff als Fremdatom dar.

Dass Schwefel so vorteilhafte Eigenschaften hat, scheint auch möglicherweise daran zu liegen, dass der Energielevel von Schwefel ziemlich gut mit dem eines Punktdefekts (V) in Diamant übereinstimmt. Es wird vermutet, dass dadurch eine sehr gute Übertragung (Mott Hopping) des Elektrons von Schwefel auf den Punktdefekt ermöglicht wird.

Weiterhin scheint bei Schwefel als Dotand das Diamantmaterial zu stabilisieren, was wohl daran liegt, dass Schwefel die Bildung von Graphit bei hohen Temperaturen durch die sich gegenseitig abstoßenden Defekte verzögert. Genauer gesagt scheint Schwefel die Bildung komplexer Defektcluster zu unterdrücken, weil sich die geladenen Vakanzen oder Punktdefekte (V-) abstoßen. Daher können die Temperaturen beim zweiten Temperierungsschritt dann höher gewählt werden, was vorteilhaft für die Umwandlungsrate ist.

In einer vorteilhaften Weiterbildung ist vorgesehen, dass das Farbzentrum ein NV-Zentrum ist. Dieses Farbzentrum ist besonders vielversprechend für Quantentechnologieanwendungen.

In einer vorteilhaften Weiterbildung ist vorgesehen, dass die Dotandenkonzentration im Bereich $10^{17}$ cm$^{-3}$ bis $10^{19}$ cm$^{-3}$, bevorzugt zwischen $1\times10^{18}$ cm$^{-3}$ und $9\times10^{18}$ cm$^{-3}$ liegt. Dadurch werden die im Rahmen der Implantation von Fremdatomen erzeugten Vakanzen negativ geladen, was dazu führt, dass die Wahrscheinlichkeit der Bildung von NV-Zentren erhöht ist und die Wahrscheinlichkeit der Bildung von VV-Zentren vermindert wird.

In einer vorteilhaften Weiterbildung ist vorgesehen, dass die Tiefe der implantierten Dotanden zumindest gleich der Tiefe der eingebauten Fremdatome ist. Dadurch stehen die vorteilhaften Wirkungen der Dotanden für alle eingebauten Fremdatome bereit, weil diese Fremdatome nicht einfach nur Defekte erzeugen, so dass sehr hohe Umwandlungsraten erreicht werden können.

In einer vorteilhaften Weiterbildung ist vorgesehen, dass die Dotandenimplantation durch einen Beschuss mit den Dotanden erfolgt, insbesondere mit Energien von kleiner gleich 150 keV. Dadurch werden sehr hohe Umwandlungsraten nahe der Oberfläche erzielt. Es können zwar auch andere Methoden für die Implementierung von Dotanden verwendet werden, allerdings liefert der Beschuss besonders gute Ergebnisse, weil damit definierte Tiefen für die Konzentrationsverteilung der Dotanden eingestellt werden können.

In einer vorteilhaften Weiterbildung ist vorgesehen, dass die Dotandenimplantation in zumindest zwei aufeinander folgenden unterschiedlichen Schritten erfolgt, weil dadurch eine sehr homogene Dotandenverteilung über die Tiefe der Diamantschicht eingestellt werden kann. Beispielsweise erfolgt die Dotandenimplantation durch Dotandenbeschuss bei unterschiedlichen Fluenzen und/oder Energien.

In einer vorteilhaften Weiterbildung ist vorgesehen, dass der Ionenbeschuss mit Fremdatomen mit einer Ionenfluenz im Bereich $10^4$ cm$^{-2}$ bis $10^{10}$ cm$^{-2}$, bevorzugt im Bereich $10^7$ cm$^{-2}$ bis $10^{10}$ cm$^{-2}$, höchst bevorzugt im Bereich $10^8$ cm$^{-2}$ bis $10^{10}$ cm$^{-2}$, insbesondere im Bereich $10^9$ cm$^{-2}$ bis $10^{10}$ cm$^{-2}$ erfolgt. Dadurch können besonders hohe Umwandlungsraten erzielt werden.

In einer vorteilhaften Weiterbildung ist vorgesehen, dass die Tiefe der Farbzentren in der Diamantschicht im Bereich 5 nm bis 100 nm, bevorzugt im Bereich 10 nm bis 50 nm, insbesondere im Bereich 10 nm bis 30 nm liegt und

EP 4 276 060 A2

vorzugsweise zwischen 20 und 30 nm beträgt. Dadurch sind die Farbzentren sehr oberflächennah angeordnet und können leicht für Quantentechnologieanwendungen verwendet werden. Genauer gesagt können die Farbzentren leicht angesprochen werden, ohne dass sie durch Oberflächeneffekte gestört werden. Zwar ist zum einen die Herstellung von Farbzentrum insbesondere nahe der Oberfläche gestört, da es hier vermehrt zu einem Bandbending kommt, was die Bildung der Farbzentren verhindert. Und zum anderen erleichtern unvermeidliche Kristallstörungen an der Oberfläche das Eindringen störender Fremdatome wie Wasserstoff. Für die Herstellung von Sensoren oder die Adressierung von Qubits sind Farbzentren an der Oberfläche jedoch unumgänglich. In dem genannten Tiefenbereich ist nun die Erzeugung ungestörter Qubits, die dennoch gut angesprochen werden können, möglich.

In einer vorteilhaften Weiterbildung ist vorgesehen, dass nach der Dotandenimplantation ein erster Temperierungsschritt erfolgt, wobei

i) die Temperierungstemperatur des ersten Temperierungsschritts bevorzugt im Bereich 800°C bis 2000°, mehr bevorzugt im Bereich 800°C bis 1400°C, insbesondere im Bereich 1000°C bis 1400°C liegt, vorzugsweise nicht mehr als 1200°C beträgt und höchst vorzugsweise im Bereich 1000°C bis 1200°C liegt und/oder

ii) die Zeit für den ersten Temperierungsschritt bevorzugt zwischen 1 h und 24 h, insbesondere zwischen 2 h und 10 h, vorzugsweise zwischen 3 h und 6 h liegt. Durch diesen ersten Temperierungsschritt werden die Dotanden elektrisch aktiviert, so dass sie leicht Ihre Ladung an die erzeugten Vakanzen und Farbzentren abgeben können. Außerdem findet dadurch ein Ausheilen von dotandenimplantationsinduzierten Defekten statt und die Dotanden werden sich auf Substitutionsplätzen anordnen, was für hohe Umwandlungsraten besonders vorteilhaft ist. Dies ist vor allem für eine Dotandenimplantation im Rahmen eines Dotandenbeschusses vorteilhaft.

Die Veröffentlichung Karin Groot-Berning et al.: "Passive charge state control of nitrogen-vacancy centres in diamond using phosphorous and boron doping", Phys. Status Solidi A 211, No. 10, 2268-2273 (2014) beschreibt einen Temperierungsschritt mit 1500 °C für das dotierte Diamantmaterial. Die Erfinder haben nun aber festgestellt, dass die Umwandlungsrate dann besonders hoch ist, wenn diese Temperierung bei nicht mehr als 1200 °C erfolgt. Der physikalische Hintergrund hierzu ist allerdings noch unbekannt.

In einer vorteilhaften Weiterbildung ist vorgesehen, dass nach der Dotandenimplantation und/oder nach dem ersten Temperierungsschritt ein Sauerstoffplasma verwendet wird, um die Oberfläche von möglicherweise auftretendem Graphit zu säubern.

In einer vorteilhaften Weiterbildung ist vorgesehen, dass nach dem Fremdatomeinbau ein zweiter Temperierungsschritt erfolgt, wobei

iii) die Temperierungstemperatur des zweiten Temperierungsschrittes vorzugsweise geringer als beim ersten Temperierungsschritt ist und/oder bevorzugt im Bereich 600°C bis 1300°C, insbesondere im Bereich 800°C bis 1000°C liegt und/oder

iv) die Zeit für den zweiten Temperierungsschritt bevorzugt zwischen 1 h und 24 h, insbesondere zwischen 2 h und 10 h, vorzugsweise zwischen 3 h und 6 h liegt. Durch den zweiten Temperierungsschritt werden sehr hohe Umwandlungsraten ermöglicht, wobei diese besonders hoch sind, wenn die Temperatur geringer ist als beim ersten Ausheizen. Dieser zweite Temperierungsschritt erhöht die Mobilität der Vakanzen und der Fremdatome, so dass die Wahrscheinlichkeit der Bildung der Farbzentren erhöht wird. Außerdem werden fremdatomimplantationsbedingte Defekte ausgeheilt, die letztlich auch eine Verschränkung der Qubits verhindern oder zumindest stören würden.

In einer vorteilhaften Weiterbildung ist vorgesehen, dass der erste Temperierungsschritt und/oder der zweite Temperierungsschritt Heizen und/oder Laser-Bestrahlung, insbesondere rapid thermal annealing umfasst. Dadurch erfolgt das Ausheizen besonders wirkungsvoll und es können sehr hohe Umwandlungsraten erzielt werden.

Erfindungsgemäß ist vorgesehen, dass eine Anhebung des Fermi-Niveaus vorgenommen wird, weil dadurch die Ladung des Defekts eingestellt werden kann. Vorzugsweise erfolgt die Anhebung des Fermi-Niveaus durch LASER-Bestrahlung, Elektronbeschuss oder Spannungsanlegung. Die Fermi-Niveauanhebung kann bevorzugt während der Fremdatomimplantation, nach der Fremdatomimplantation und/oder während des zweiten Temperierungsschritts erfolgen. Aber auch Schwefel scheint dafür zu sorgen, dass das Fermi-Niveau angehoben wird, wodurch die Umwandlungsrate erhöht wird.

In einer vorteilhaften Weiterbildung ist vorgesehen, dass die Diamantschicht in einem Diamantmaterial vorliegt, das zumindest Reinqualität ("electronic grade") aufweist. Vorzugsweise soll der Wasserstoffgehalt in der Diamantschicht kleiner $10^{17}$ cm$^{-3}$ sein. Dadurch lassen sich besonders hohe Umwandlungsraten erzielen. Vorteilhaft wird zusätzlich Schwefel als Donator verwendet, weil dadurch Wasserstoff gebunden zu werden scheint, was die Umwandlungsrate zusätzlich erhöht.

In einer vorteilhaften Weiterbildung ist vorgesehen, dass die Diamantschicht als Schicht, bevorzugt als Oberflächenschicht, innerhalb eines sich über eine größere Tiefe erstreckenden Diamantmaterials ausgebildet ist. Dann ist das Farbzentrum besonders einfach herstellbar. Alternativ können allerdings auch Diamantschichten mit bekannten Verfahren direkt auf Substraten erzeugt werden.

Selbständiger Schutz wird beansprucht für die erfindungsgemäße Diamantschicht mit zumindest einem deterministischen Farbzentrum, die dadurch gekennzeichnet ist, dass die zur Bildung des Farbzentrums verwendete Fremdatomsorte in einer Atomanzahl in der Diamantschicht vorliegt, die höchstens doppelt so groß ist, wie die Anzahl des Farbzentrums in der Diamantschicht, wobei die Diamantschicht mit dem erfindungsgemäßen Verfahren hergestellt wurde. Dies entspricht einer Umwandlungsrate von mindestens 50%, weil dann von zwei eingebrachten Fremdatomen eines zur Bildung eines Farbzentrums beiträgt. Bevorzugt soll die zur Bildung des Farbzentrums verwendete Fremdatomsorte in einer Atomanzahl in der Diamantschicht vorliegen, die höchstens 1,67 (dies entspricht einer Umwandlungsrate von mindestens 60%) mal so groß, insbesondere höchstens 1,43 (dies entspricht einer Umwandlungsrate von mindestens 70%) mal so groß ist, wie die Anzahl des Farbzentrums in der Diamantschicht.

Außerdem wird selbständiger Schutz beansprucht für die erfindungsgemäße Verwendung der erfindungsgemäßen Diamantschicht bzw. der erfindungsgemäß hergestellten Diamantschicht als Qubit-Behälter, bevorzugt im Rahmen eines Sensors und/oder im Rahmen von Quantenkryptographie und/oder im Rahmen einer Quantencomputeranwendung. Beispielsweise könnte ein Farbzentrum, das in der Diamantschicht als Qubit wirkt, insbesondere ein NV-Zentrum, in einer AFM-Spitze, für besonders genaue Messungen eingesetzt werden.

Wie gesagt, werden zwar auch bei der EP 3 098 335 B1 Dotanden verwendet, allerdings nur, um die optischen Eigenschaften des schon bestehenden Farbzentrums zu beeinflussen, nämlich schon vorhandene NV°-Zentren in NV⁻-Zentren umzubilden bzw. die Langzeitstabilität von NV-Zentren zu gewährleisten, während im Rahmen der vorliegenden Erfindung der Dotand zur deterministischen Bildung des Farbzentrums selbst verwendet wird. Auch die erfindungsgemäße Reihenfolge der Implantation und des Ausheilprozesses wirken sich hierbei vorteilhaft aus. Während bei der EP 3 098 335 nur ein Ausheilschritt (Temperierungsschritt) nach der Implantation von Dotand und Fremdatom zur Ladungsstabilität des Farbzentrums erfolgt, wird bei dem erfindungsgemäßen Verfahren ein weiterer Ausheilschritt (Temperierungsschritt) zwischen der Implantation von Dotand und Fremdatom verwendet. Nur damit kann das chemische Potenzial gezielt positiv verändert und das Verhalten der Defekte bei der Implantation der Atome des Farbzentrums im zweiten erfindungsgemäßen Verfahrensschritt kontrolliert werden Die Wirkungsweise der bei dem erfindungsgemäßen Verfahren implantierten Dotanden ist somit deutlich von dem in EP 3 098 335 B1 durchgeführten Verfahren zu unterscheiden.

Die Merkmale und weitere Vorteile der vorliegenden Erfindung werden im Folgenden anhand der Beschreibung bevorzugter Ausführungsbeispiele im Zusammenhang mit den Figuren deutlich. Dabei zeigen rein schematisch:

Fig. 1    Blockschema des erfindungsgemäßen Verfahrens,
Fig. 2    Darstellung der Probenpräparation,
Fig. 3    Konzentrationsverteilung der Dotanden,
Fig. 4    Verfahren zur Bestimmung des Hintergrundsignals,
Fig. 5    Verfahren zur Bestimmung des Referenzsignals,
Fig. 6    erzielte Umwandlungsraten für Stickstoff,
Fig. 7    Veränderung der Fluoreszenz in Abhängigkeit vom zweiten Temperierungsschritt und
Fig. 8    Übersicht über die bestimmten Kohärenzzeiten.

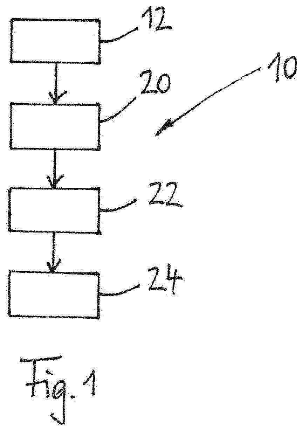

In Fig. 1 ist zu erkennen, dass das erfindungsgemäße Verfahren 10 zur Herstellung eines deterministischen Farbzentrums bevorzugt in vier Schritten durchgeführt wird.

In einem ersten Schritt 12 werden einem Diamant 14 (Typ IIa, CVD-gewachsen, "electronic grade", Verunreinigungen: [N] < 5 ppb, [B] < 1 ppb, (001)-Fläche poliert, nach oben liegend) Dotanden in einer Diamantschicht 15 (entspricht der Tiefenausdehnung des dotierten Bereichs des Diamanten bzw. der Tiefenausdehnung der später erzeugten Farbzentren 54) des Diamanten 14 implantiert. Dies erfolgt mit einer Ionenstrahlquelle 16, wobei bevorzugt eine Blende 18 zur lokalen Festlegung der Implantation verwendet wird.

Die Ionenstrahlquelle 16 besitzt eine Cäsium-Sputterquelle, die auf unterschiedliche Kathoden einwirkt, wonach die herausgesputterten Ionen in einem elektrischen Feld beschleunigt werden.

Anschließend erfolgt ein erster Temperierungsschritt 20 zum Ausheilen von Defekten, die im Rahmen der Implantation entstanden sind. Außerdem ordnen sich dadurch die Dotanden auf den Substitutionsplätzen im Diamantgitter an. Zusätzlich erfolgt eine elektrische Aktivierung der Dotanden, so dass diese ihre Ladung leicht abgeben. Für den ersten Temperierungsschritt wird ein bestimmtes erstes Temperregime verwendet, das die Einwirkung einer bestimmten Temperatur über eine bestimmte Zeit vorsehen kann oder auch verschiedene nachfolgend über jeweils bestimmte Zeiten angewendete Temperaturen.

Vorzugsweise kann nach dem ersten Temperierungsschritt 20 ein Sauerstoffplasma verwendet werden, um die Oberfläche von möglicherweise auftretendem Graphit zu säubern.

Anschließend erfolgt zum Einbau der Fremdatome ein Ionenbeschuss 22 wiederum mit der Ionenstrahlquelle 16, bspw. vom Typ Kaufmann, wobei bevorzugt wiederum die zusätzliche Blende 18 mit einer Blendenöffnung von 50

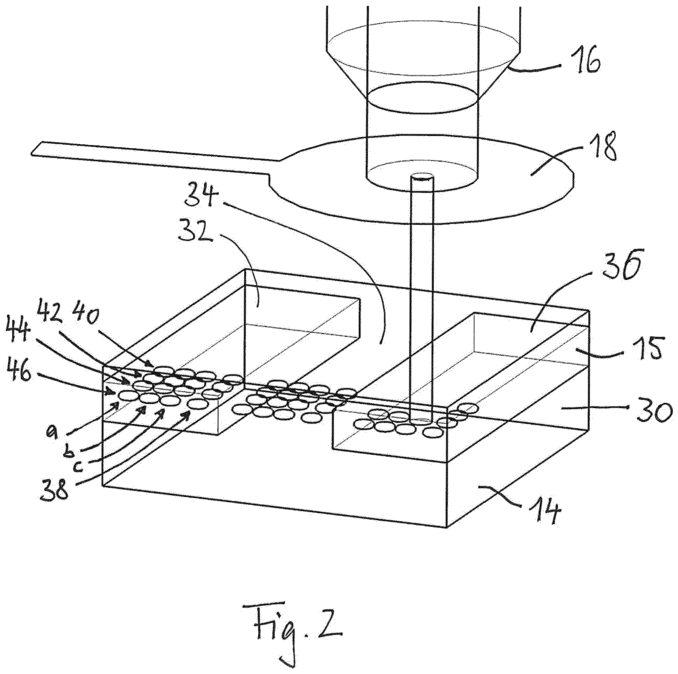

μm verwendet wird (vgl. Fig. 2).

Schließlich erfolgt ein zweiter Temperierungsschritt 24 zum Ausheilen von Defekten, die im Rahmen des Einbaus der Fremdatome erzeugt wurden bzw. um durch Erhöhung der Mobilität die Vakanzdefekte zu den Fremdatomen zu führen, um so Farbzentren zu bilden. Für den zweiten Temperierungsschritt wird ein bestimmtes zweites Temperregime verwendet, das ebenfalls die Einwirkung einer bestimmten Temperatur über eine bestimmte Zeit vorsehen kann oder auch verschiedene nachfolgend über jeweils bestimmte Zeiten angewendete Temperaturen.

Das Temperieren 20, 24 kann jeweils mit einer gebräuchlichen Temperierungsmethode erfolgen, wobei diese bevorzugt aus der Gruppe Heizen, beispielsweise mit einer Heizplatte, IR-Strahlungswärme und/oder LASER-Bestrahlung gewählt ist, jedoch auch andere Methoden verwendet werden können.

Während zumindest einer der Schritte 22, 24 kann zusätzlich eine Anhebung des Fermi-Niveaus erfolgen, was bevorzugt mittels LASER-Bestrahlung, Elektronbeschuss oder Spannungsanlegung erfolgt.

In Fig. 2 ist gezeigt, wie einzelne Versuchsproben 30 hergestellt wurden.

Dabei sind jeweils räumlich voneinander abgegrenzte Dotierungs-Bereiche 32, 34, 36 vorgesehen, die durch unterschiedliche Dotierungen mittels des ersten Schrittes 12 entstehen. Dabei können einzelne Dotierungsbereiche für Vergleichszwecke auch undotiert bleiben.

Im Rahmen von Versuchsprobe 30 handelt es sich bei Dotierung-Bereich 32 um einen Bordotierten Bereich, bei Dotierungs-Bereich 34 um einen undotierten (intrinsischen Bereich) und bei Dotierungs-Bereich 36 um einen Phosphor-dotierten Bereich. Es wurden auch andere Dotierungsbereiche (nicht gezeigt) verwendet, bei denen Sauerstoff und Schwefel als Dotanden eingesetzt wurden.

Um eine möglichst homogene Dotierung von $2 \times 10^{17} cm^{-3}$ bzw. $2 \times 10^{18} cm^{-3}$ zu erreichen, erfolgte die Implantation von Bor/Phosphor in jeweils drei Schritten (drei verschiedene Energien und drei verschiedene Flüsse).

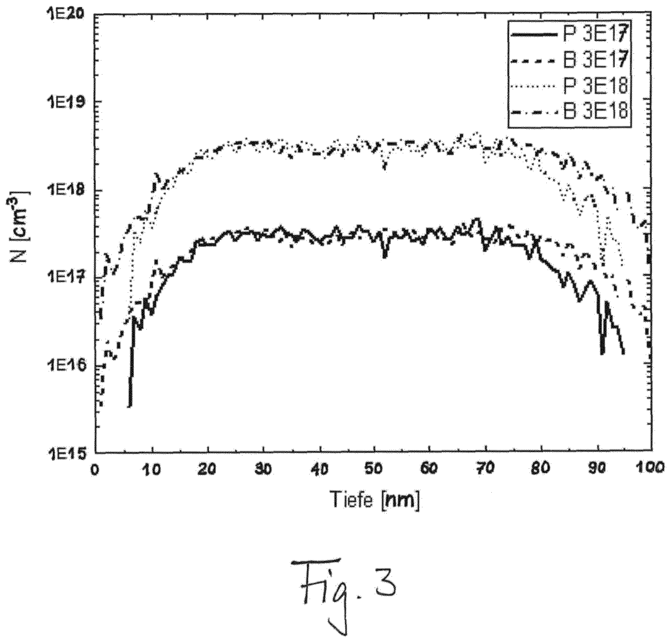

Die in Fig. 3 dargestellten Konzentrationsverteilungen der Dotanden zeigen über die Tiefe, die zwischen ca. 25 nm und ca. 75 nm mit einem Zentrum bei rund 50 nm liegt, ein sehr konstantes Plateau mit den folgenden Flüssen (vgl. Tabellen 1 und 2, simuliert mittels SRIM):

**Tabelle 1:**

| Bor | | |
|---|---|---|
| Energie (keV) | Fluenz ($cm^{-2}$) für $2 \times 10^{17} cm^{-3}$ | Fluenz ($cm^{-2}$) für $2 \times 10^{18} cm^{-3}$ |
| 12 | $5,6 \times 10^{11}$ | $5,6 \times 10^{12}$ |
| 25 | $6,4 \times 10^{11}$ | $6,4 \times 10^{12}$ |
| 40 | $1,1 \times 10^{12}$ | $1,1 \times 10^{13}$ |

**Tabelle 2:**

| Phosphor | | |
|---|---|---|
| Energie (keV) | Fluenz ($cm^{-2}$) für $2 \times 10^{17} cm^{-3}$ | Fluenz ($cm^{-2}$) für $2 \times 10^{18} cm^{-3}$ |
| 30 | $3,4 \times 10^{11}$ | $3,4 \times 10^{12}$ |
| 50 | $5,1 \times 10^{11}$ | $5,1 \times 10^{12}$ |
| 90 | $1,3 \times 10^{12}$ | $1,3 \times 10^{13}$ |

Im Rahmen des ersten Temperierungsschritts 20 wurden diese erzeugten Versuchsproben 30 temperiert, nämlich beispielsweise mit 1200°C oder 1600 °C über 4 h.

In den einzelnen Dotierungsbereichen 32, 34, 36 wurden jeweils Graphit-Marker 38 zur Orientierung auf den Proben aufgebracht. Dies geschah durch Hochdosisimplantation von Kohlenstoff, was zu einer Graphitisierung dieser Regionen führte.

Neben den Graphitmarkern 38 wurden dann verschiedene Fremdatombereiche 40, 42, 44, 46 durch Ionenbeschuss 22 erzeugt. Die Fremdatombereiche 40 betreffen beispielsweise jeweils Kohlenstoff als Fremdatom, die Fremdatombereiche 42 betreffen beispielsweise jeweils Stickstoff als Fremdatom, die Fremdatombereiche 44 betreffen beispielsweise jeweils Zinn als Fremdatom und die Fremdatombereiche 46 betreffen beispielsweise jeweils Magnesium als Fremdatom.

Dabei wurden jeweils drei unterschiedliche Flüsse a, b, c verwendet, nämlich beispielsweise anhand Versuchsprobe 30 eine Fluenz von $10^{10}$ $cm^{-2}$ für die Fremdatombereiche 40a, 42a, 44a, 46a, eine Fluenz von $10^{11}$ $cm^{-2}$ für die

Fremdatombereiche 40b, 42b, 44b, 46b und eine Fluenz von $10^{12}$ cm$^{-2}$ für die Fremdatombereiche 40c, 42c, 44c, 46.

Für Kohlenstoff, Stickstoff und Magnesium wurden Beschussenergien von 28 keV, 40 keV und 50 keV verwendet, um ein möglichst homogenes Tiefenprofil (Diamantschicht 15, durchschnittliche Implantationstiefe 50 nm) über denselben Tiefenbereich wie die Dotanden zu erzeugen. Für Zinn war dies aufgrund dessen Atommasse verbunden mit der Limitierung der Ionenstrahlquelle auf 100 keV nicht möglich, so dass dort nur 80 keV zum Einsatz kam (durchschnittliche Implantationstiefe 25 nm). Dabei kamen als Kathodenmaterial im Rahmen des jeweiligen Beschusses 22 eine Kohlenstoff-Kathode für Kohlenstoff-Fremdatome, eine $^{12}$C$^{14}$N-Kathode für Stickstoff-Fremdatome, eine $^{24}$Mg$^1$H-Kathode für Magnesium-Fremdatome und eine Zinn-Kathode für Zinn-Fremdatome zum Einsatz.

Die damit erreichten Implantierungstiefen entsprachen denen der Dotandenverteilung (Diamantschicht 15). Außerdem waren sie gering genug, um eine nur geringe Ionenstreuung von weniger als 10 nm zu erreichen, gleichzeitig jedoch groß genug, um die beschriebenen negativen Effekte der Diamantoberfläche auszuschließen bzw. zu minimieren.

Anschließend erfolgte jeweils der zweite Temperierungsschritt 24, wobei hierfür unterschiedliche Temperaturen von 600°C, 800°C, 1000°C und 1200°C verwendet wurden.

Danach wurden die Fluoreszenzintensitäten für die einzelnen Fremdatombereiche 40, 42, 44, 46 hinsichtlich aller Flüsse a, b, c mittels konfokalen Fluoreszenzmikroskops bestimmt, wobei die Graphitmarker 38 zur Orientierung und Wiederauffindung dienten.

Hierzu wurden entweder Luft- oder Ölobjektive und zwei mögliche LASER-Anregungen von 532 nm und 488 nm verwendet. Die LASER-Reflexion wurde mit einem Notch-Filter unterdrückt und unterschiedliche Spektralfilter wurden verwendet, um die gewünschten Fluoreszenzbänder auszuwählen: neutrale Leerstellen $V^0$ (GR1-Zentrum mit ZPL bei 741 nm), NV-Zentrum (ZPL von NV$^0$ bei 575 nm, ZPL von NV$^-$ bei 638 nm), SnV-Zentrum (ZPL bei 620 nm) und MgV-Zentrum (ZPL bei 557 nm).

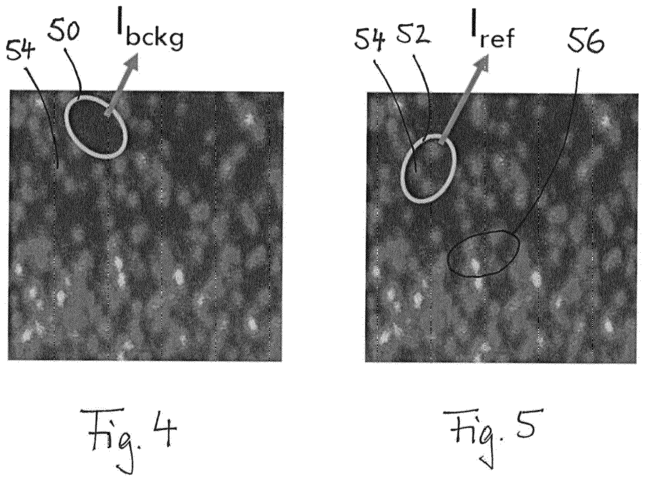

Dabei wurde in einem bestimmten Bereich 50 (vgl. Fig. 4), in dem keine Farbzentren erschienen, die Hintergrundintensität ($I_{backg}$) bestimmt und in einem geometrisch identisch großen Bereich 52 (vgl. Fig. 5), in dem eine abzählbare Anzahl Farbzentren 54 liegt, die Intensität dieser Farbzentren 54 ($I_{ref}$) bestimmt.

Die in den Fig. 4 und 5 gezeigten Ausschnitte weisen Kantenlängen von ca. $10 \times 10~\mu$m$^2$ auf. Farbzentren 54 erscheinen in solchen Aufnahmen üblicherweise dann unterscheidbar, also zählbar, wenn ihre Anzahl nicht 3 bis 4 pro $\mu$m$^2$ übersteigt.

Wenn die Farbzentren 54 so auszählbar waren, konnten durch Vergleich mit den auf diese Fläche eingeflossenen Ionen direkt auf die Umwandlungsrate geschlossen werden.

Wenn dies nicht möglich war, wurde die Umwandlungsrate wie folgt über Referenzwerte ermittelt. Der Referenzwert ($I_{single}$) pro Farbzentrum 54 wird dabei wie folgt bestimmt:

$$I_{single} = (I_{ref} - I_{bckg}) / (\text{Anzahl der Farbzentren 54 im Bereich 52})$$

Für einen beliebigen Bereich 56 kann nun die Dichte $D_{FZ}$ der Farbzentren 54 mithilfe der folgenden Beziehung aus der Gesamtintensität $I_{ens}$ aus der Fläche S dieses Bereichs 56 bestimmt werden:

$$D_{FZ} = 1/S * (I_{ens} - I_{backg}) / I_{single}.$$

Daraus kann die Umwandlungsrate UR bestimmt werden durch:

$$UR = D_{FZ} / (\text{Ionenfluenz beim Fremdatomeinbau}).$$

Schließlich wurden noch die Spin-Kohärenzzeit T2 und T2* bestimmt.

Es wurde festgestellt, dass die Umwandlungsrate für NV-Zentren 54 für intrinsischen Diamant bei ca. 6%-8% liegt.

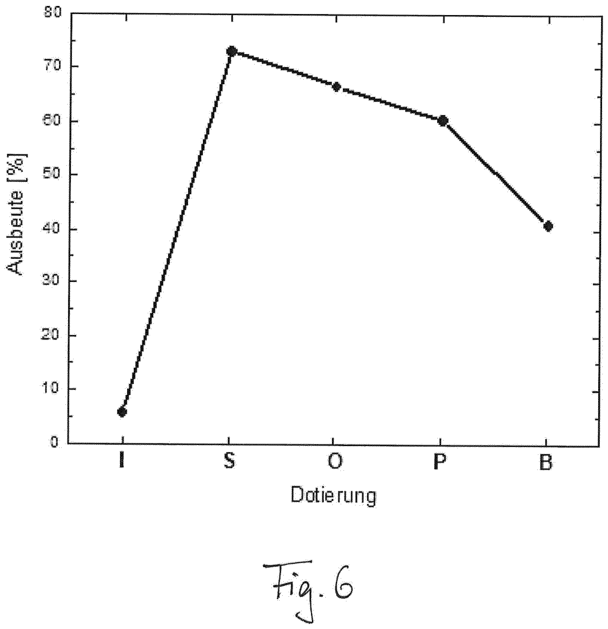

Durch eine Dotierung mit Schwefel, Sauerstoff, Phosphor oder Bor kann die Umwandlungsrate bedeutend erhöht werden (Schwefel: ~75 %, Sauerstoff: ~70 %, Phosphor: ~60 % und Bor: ~40 % - vgl. Fig. 6). Dabei können allerdings nur mit Schwefel, Sauerstoff und Phosphor NV-Zentren erzeugt werden, die Qubits ermöglichen. Diese Werte wurden mit folgenden Parametern erzielt: Für die Dotierung wurden Fluenzen und Energien von Phosphor: 40 keV bei $4,1 \times 10^{12}$ cm$^{-2}$ und 80 keV bei $4,1 \times 10^{12}$ cm$^{-2}$, Sauerstoff: 25 keV bei $2,1 \times 10^{12}$ cm$^{-2}$ und 50 keV bei $4,2 \times 10^{12}$ cm$^{-2}$, Schwefel: 40 keV bei $1,6 \times 10^{12}$ cm$^{-2}$ und 80 keV bei $3,7 \times 10^{12}$ cm$^{-2}$ sowie Bor: 25 keV bei $2,1 \times 10^{12}$ cm$^{-2}$ und 50 keV bei $4,2 \times 10^{12}$ cm$^{-2}$ verwendet, während die Fremdatomimplantation mit Stickstoff bei einer Fluenz von maximal $10^{10}$ cm$^{-2}$ und einer Energie von 40 KeV erfolgte.

Obwohl dies nicht zu erwarten war, können also vor allem mit Schwefel sehr hohe Umwandlungsraten erzielt werden.

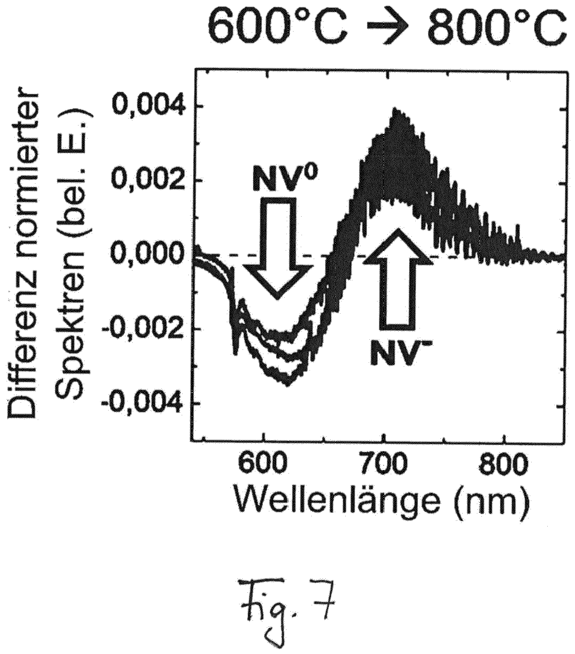

Eine höhere Temperatur im zweiten Temperierungsschritt 24 kann zu einer höheren Umwandlungsrate zu NV-Zentren führen (vgl. Fig. 7, wo dies anhand der Differenz der normalisierten Fluoreszenzspektren für Phosphor als Dotanden und einer Temperierungsveränderung von 600°C auf 800°C für verschiedene Proben gezeigt ist), was dadurch erklärt werden kann, dass durch die höhere Temperatur Fehlstellen, die als Akzeptoren wirken, ausgeheilt werden und außerdem eine höhere Mobilität der Vakanzen von des Stickstoffs bewirkt wird.

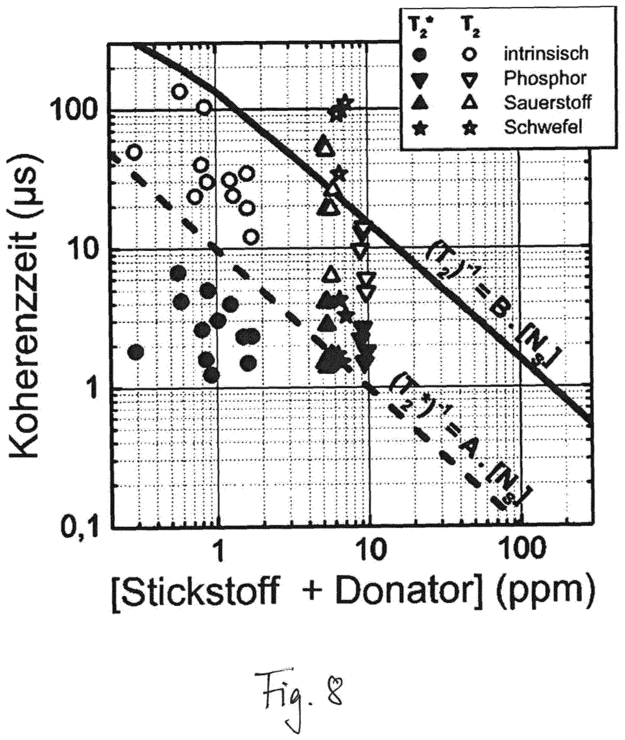

Anhand von Fig. 8 ist erkennbar, dass die Kohärenzzeiten für Schwefeldotierung ausgezeichnet, das heißt so hoch sind, als wenn gar keine Dotierung bestehen, sondern ein intrinsischer Diamant vorliegen würde. Für Sauerstoff sind die Kohärenzzeiten noch sehr gut, während für eine Phosphordotierung nicht so gute Kohärenzzeiten erzielt werden können.

Für Magnesium und Zinn wurden ähnliche Ergebnisse erzielt, so dass insgesamt festgestellt werden kann, dass durch eine Dotierung die Umwandlungsraten deutlich erhöht werden können. Dabei kann durch eine Dotierung mit einem Donator, wie Phosphor, Sauerstoff oder Schwefel, eine sehr gute Umwandlungsrate in negativ geladene Farbzentren erreicht werden, die für Qubit-Anwendungen eingesetzt werden können.

Aufgrund der hohen Umwandlungsraten wird somit eine Möglichkeit gegeben, Farbzentren in Diamant deterministisch zu erzeugen.

Soweit nichts anders angegeben ist, können sämtliche Merkmale der vorliegenden Erfindung frei miteinander kombiniert werden. Auch die in der Figurenbeschreibung beschriebenen Merkmale können, soweit nichts anderes angegeben ist, als Merkmale der Erfindung frei mit den übrigen Merkmalen kombiniert werden. Eine Beschränkung einzelner Merkmale der Ausführungsbeispiele auf die Kombination mit anderen Merkmalen der Ausführungsbeispiele ist dabei ausdrücklich nicht vorgesehen. Außerdem können gegenständliche Merkmale der Diamantschicht umformuliert auch als Verfahrensmerkmale Verwendung finden und Verfahrensmerkmale umformuliert als gegenständliche Merkmale der Diamantschicht. Eine solche Umformulierung ist somit automatisch mit offenbart.

Bezugszeichenliste

| | |
|---|---|
| 10 | erfindungsgemäßes Verfahren zur Herstellung eines deterministischen Farbzentrums |
| 12 | erster Schritt, Implantation von Dotanden |
| 14 | Diamant |
| 15 | Diamantschicht |
| 16 | Ionenstrahlquelle |
| 18 | Blende |
| 20 | erster Temperierungsschritt |
| 22 | zweiter Schritt, Ionenbeschuss |
| 24 | zweiter Temperierungsschritt |
| 30 | Versuchsprobe |
| 32, 34, 36 | Dotierungs-Bereiche |
| 38 | Graphit-Marker |
| 40, 42, 44, 46 | Fremdatombereiche |
| 50 | bestimmter Bereich der Diamantschicht ohne Farbzentren |
| 52 | geometrisch identisch großer Bereich wie der bestimmte Bereich 50 |
| 54 | Farbzentren, NV-Zentren |
| 56 | beliebiger Bereich |
| a, b, c | Fremdatombereiche 40, 42, 44, 46 mit unterschiedlichen Ionenflüssen |
| $D_{FZ}$ | Dichte der Farbzentren 54 mithilfe der folgenden Beziehung aus der |
| $I_{backg}$ | Hintergrundintensität |
| $I_{ens}$ | Gesamtintensität |
| $I_{ref}$ | Intensität der Farbzentren 54 |
| $I_{single}$ | Referenzwert |
| S | Fläche des Bereichs 56 |
| T2, T2* | Spin-Kohärenzzeiten |
| UR | Umwandlungsrate |

**Patentansprüche**

1. Verfahren (10) zur Erzeugung zumindest eines deterministischen Farbzentrums (54) in einer Diamantschicht (15), **dadurch gekennzeichnet, dass**

   in einem ersten Schritt (12) in der Diamantschicht (15) zumindest ein Dotand implantiert wird und
   in einem zweiten Schritt (22) in der Diamantschicht (15) mittels niederenergetischem Ionenbeschuss zumindest ein Fremdatom zur Bildung des Farbzentrums (54) eingebaut wird, wobei der Ionenbeschuss (22) mit Fremdatomen mit einer Ionenfluenz bis zu $10^{10}$ cm$^{-2}$ erfolgt,
   wobei eine Anhebung des Fermi-Niveaus vorgenommen wird.

2. Verfahren (10) nach Anspruch 1, **dadurch gekennzeichnet, dass** die Anhebung des Fermi-Niveaus während der Fremdatomimplantation (22), nach der Fremdatomimplantation (22) und/oder während des zweiten Temperierungsschritts (24) erfolgt, wobei die Anhebung insbesondere durch LASER-Bestrahlung, Elektronbeschuss oder Spannungsanlegung erfolgt.

3. Verfahren (10) nach Anspruch 1 oder 2, **dadurch gekennzeichnet,**

   **dass** als Dotand ein Donator, bevorzugt Phosphor, Sauerstoff, Schwefel oder Lithium, oder ein Akzeptor, bevorzugt Bor, verwendet wird und/oder
   **dass** das Fremdatom gewählt ist aus der Gruppe Stickstoff, Magnesium, Kohlenstoff, Blei, Bor, Edelgase, Silizium, Übergangsmetalle und Zinn.

4. Verfahren (10) nach einem der vorherigen Ansprüche, **dadurch gekennzeichnet, dass** das Farbzentrum ein NV-Zentrum (54) ist und/oder
   **dass** der Ionenbeschuss (22) mit Fremdatomen mit einer Ionenfluenz im Bereich $10^4$ cm$^{-2}$ bis $10^{10}$ cm$^{-2}$, bevorzugt im Bereich $10^7$ cm$^{-2}$ bis $10^{10}$ cm$^{-2}$, höchst bevorzugt im Bereich $10^8$ cm$^{-2}$ bis $10^{10}$ cm$^{-2}$, insbesondere im Bereich $10^9$ cm$^{-2}$ bis $10^{10}$ cm$^{-2}$, erfolgt.

5. Verfahren (10) nach einem der vorherigen Ansprüche, **dadurch gekennzeichnet, dass** die Dotandenkonzentration im Bereich $10^{17}$ cm$^{-3}$ bis $10^{19}$ cm$^{-3}$, bevorzugt zwischen $1 \times 10^{18}$ cm$^{-3}$ und $9 \times 10^{18}$ cm$^{-3}$ liegt und/oder

   **dass** die Dotandenimplantation (12) durch einen Beschuss mit den Dotanden erfolgt, insbesondere mit Energien von kleiner gleich 150 keV und/oder einer Dotandenfluenz im Bereich $10^9$ cm$^{-2}$ bis $10^{13}$ cm$^{-2}$, bevorzugt im Bereich $10^{10}$ cm$^{-2}$ bis $10^{12}$ cm$^{-2}$, insbesondere im Bereich $10^{11}$ cm$^{-2}$ bis $10^{12}$ cm$^{-2}$ und/oder
   **dass** die Dotandenimplantation (12) in zumindest zwei aufeinander folgenden unterschiedlichen Schritten erfolgt, wobei die Dotandenimplantation (12) bevorzugt durch Dotandenbeschuss bei unterschiedlichen Fluenzen und/oder Energien erfolgt.

6. Verfahren (10) nach einem der vorherigen Ansprüche, **dadurch gekennzeichnet, dass** die Tiefe der implantierten Dotanden zumindest gleich der Tiefe der eingebauten Fremdatome ist und/oder
   **dass** die Tiefe der Farbzentren (54) in der Diamantschicht (15) im Bereich 5 nm bis 100 nm, bevorzugt im Bereich 10 nm bis 50 nm, besonders bevorzugt im Bereich 10 nm bis 30 nm liegt und insbesondere zwischen 20 und 30 nm beträgt.

7. Verfahren (10) nach einem der vorherigen Ansprüche, **dadurch gekennzeichnet, dass** nach der Donatorimplantation (12) ein erster Temperierungsschritt (20) erfolgt, wobei

   i) die Temperierungstemperatur des ersten Temperierungsschritts (20) bevorzugt im Bereich 800°C bis 2000°, insbesondere im Bereich 800°C bis 1400°C liegt und vorzugsweise im Bereich 1000°C bis 1200°C beträgt und/oder
   ii) die Zeit für den ersten Temperierungsschritt (20) bevorzugt zwischen 1 h und 24 h, insbesondere zwischen 2 h und 10 h, vorzugsweise zwischen 3 h und 6 h liegt.

8. Verfahren (10) nach einem der vorherigen Ansprüche, **dadurch gekennzeichnet, dass** nach dem Fremdatomeinbau (22) ein zweiter Temperierungsschritt (24) erfolgt, wobei

   iii) die Temperierungstemperatur des zweiten Temperierungsschrittes (24) vorzugsweise geringer als beim ersten Temperierungsschritt (20) ist und/oder bevorzugt im Bereich 600°C bis 1300°C, insbesondere im Bereich 800°C bis 1000°C liegt und/oder
iv) wobei die Zeit für den zweiten Temperierungsschritt (24) bevorzugt zwischen 1 h und 24 h, insbesondere zwischen 2 h und 10 h, vorzugsweise zwischen 3 h und 6 h liegt.

9. Verfahren (10) nach einem der vorherigen Ansprüche, **dadurch gekennzeichnet,**

   **dass** die Diamantschicht (15) in einem Diamantmaterial (14) vorliegt, das zumindest Reinqualität aufweist, wobei der Wasserstoffgehalt in der Diamantschicht (15) bevorzugt kleiner $10^{17}$ $cm^{-3}$ ist, und/oder
   **dass** die Diamantschicht (15) als Schicht, bevorzugt als Oberflächenschicht, innerhalb eines sich über eine größere Tiefe erstreckenden Diamantmaterials (14) ausgebildet ist.

10. Diamantschicht (15) mit zumindest einem deterministischen Farbzentrum (54), **dadurch gekennzeichnet ist, dass** die zur Bildung des Farbzentrums (54) verwendete Fremdatomsorte in einer Atomanzahl in der Diamantschicht (15) vorliegt, die höchstens doppelt so groß ist, wie die Anzahl des Farbzentrums (54) in der Diamantschicht (15), wobei die Diamantschicht nach einem der vorherigen Ansprüche hergestellt wurde.

11. Verwendung einer Diamantschicht (15) mit zumindest einem deterministischen Farbzentrum (54) nach Anspruch 10 oder hergestellt nach einem der Ansprüche 1 bis 9 als Qubit-Behälter.

12. Verwendung nach Anspruch 11, **dadurch gekennzeichnet ist, dass** die Verwendung im Rahmen eines Sensors und/oder im Rahmen von Quantenkryptographie und/oder im Rahmen einer Quantencomputeranwendung erfolgt.

Fig. 1

Fig. 2

Fig. 3

$I_{bckg}$

Fig. 4

$I_{ref}$

Fig. 5

Fig. 6

Fig. 7

Fig. 8

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 7122837 B2
- EP 3098335 B1
- EP 3098335 A

**In der Beschreibung aufgeführte Nicht-Patentliteratur**

- **KARIN GROOT-BERNING et al.** Passive charge state control of nitrogen-vacancy centres in diamond using phosphorous and boron doping. *Phys. Status Solidi A,* 2014, vol. 211 (10), 2268-2273